# FASCICULE DE BREVET EUROPEEN

(11) **EP 2 518 896 B1**
(45) Date de publication et mention de la délivrance du brevet: **04.06.2014**
(21) Numéro de dépôt: 12162851.5
(22) Date de dépôt: 02.04.2012
(51) Int. Cl.: H03F 3/26, H03F 3/30

(54) **Amplificateur**
Verstärker
Amplifier

(30) Priorité: 27.04.2011 FR 1153603
(43) Date de publication de la demande: 31.10.2012
(73) Titulaire: EASII IC, 38000 Grenoble (FR)
(72) Inventeur: Huffenus, Alexandre, 38000 GRENOBLE (FR); Pontarollo, Serge, 38120 SAINT EGREVE (FR)
(74) Mandataire: de Beaumont, Michel

(56) Documents cités:
- US-A- 5 642 078
- US-A- 6 127 891
- US-A1- 2002 180 529
- US-A1- 2009 102 551

## Description

### Domaine de l'invention

La présente invention concerne de façon générale les amplificateurs et, plus particulièrement, les amplificateurs audio. L'invention s'applique plus particulièrement à la réalisation d'un étage de sortie d'un tel amplificateur.

### Exposé de l'art antérieur

On connaît de nombreux circuits électroniques réalisant des fonctions d'amplificateurs audio. Ces amplificateurs sont généralement constitués de plusieurs étages successifs entre un étage d'entrée auquel est appliqué un signal à amplifier et un étage de sortie dont une borne de sortie fournit un signal électrique à un haut-parleur. Les différents étages d'amplification sont généralement des étages différentiels, l'étage de sortie étant un étage à entrées différentielles et à sortie non différentielle.

Un exemple d'amplificateur avec cette structure peut être trouvé dans le document de brevet US 5, 642, 078.

Un problème récurrent dans les amplificateurs est la consommation et les pertes dans des transistors de l'étage de sortie en raison du faible niveau du signal utile par rapport à la tension d'alimentation. Ce problème est particulièrement sensible dans les dispositifs portables alimentés par une batterie. Il faut pouvoir diminuer la tension d'alimentation au repos ou lorsque l'amplitude du signal à amplifier est faible.

On a déjà proposé d'utiliser une alimentation à découpage permettant de baisser la tension d'alimentation de l'étage de sortie en fonction du niveau requis pour le signal de sortie. Dans ce genre de circuit, la tension d'alimentation des transistors en série de l'étage de sortie est variable et régulée en fonction des besoins liés au niveau du signal d'entrée.

La valeur minimale de cette tension doit respecter un fonctionnement correct des transistors en série de l'étage de sortie. Même en utilisant des transistors MOS à faible tension de seuil, le rendement reste insatisfaisant.

Pour améliorer le fonctionnement, notamment le taux de distorsion harmonique, de ces amplificateurs, des systèmes ajustent le courant dans les transistors MOS de l'étage de sortie. Pour cela, on contrôle leur tension de grille en fonction du résultat d'une mesure du courant qui les traverse. Ces systèmes permettent de régler un courant à une valeur suffisante au fonctionnement de l'étage de sortie, le courant minimum des transistors de l'étage de sortie lorsque le niveau de tension de sortie est nul (amplificateur au repos).

Les étages de sortie auxquels s'applique la présente invention sont des étages dits push-pull, généralement constitués de deux transistors MOS en série entre les deux bornes d'alimentation, la borne de sortie correspondant au point milieu de cette association en série. Il est alors souhaitable que, même en fonctionnement, celui des transistors qui ne sert pas à amplifier le signal soit traversé par un courant minimum.

Le brevet américain 6366165 décrit un amplificateur utilisant les mêmes tensions d'alimentation pour l'étage de sortie et le contrôle des tensions de grilles des transistors de l'étage de sortie. Cela nécessite une tension d'alimentation supérieure à une tension de seuil d'un transistor MOS, ce qui dégrade le rendement pour des signaux de faible amplitude.

Le brevet américain 5055797 décrit une solution dans laquelle les polarisations respectives de deux transistors MOS à canal N d'un étage de sortie sont asservies à partir d'une mesure des courants dans chacun des transistors. Cette mesure est effectuée grâce à des résistances de conversion courant-tension intercalées dans l'association en série des transistors de sortie. Cette mesure est ensuite exploitée pour contrôler la polarisation des grilles de ces transistors et, par ce biais, leurs courants respectifs. La présence de ces résistances en série avec les transistors de sortie introduit des pertes supplémentaires. De plus, les valeurs de ces résistances ne sont pas négligeables, faute de quoi elles engendreraient une imprécision inacceptable des mesures.

Prévoir des transistors de mesure a déjà été envisagé (par exemple dans le brevet américain 4853645), mais la tension minimale d'alimentation de l'étage de sortie reste importante.

D'autres circuits fixent la tension grille-source des transistors de sortie de façon fixe (sans asservissement). C'est le cas par exemple de la solution proposée dans le brevet américain 5783970.

Toutes ces solutions sont sensibles à des variations de température et à d'éventuels défauts d'appariements des transistors.

### Résumé

Un objet d'un mode de réalisation de la présente invention est de proposer un amplificateur qui pallie tout ou partie des inconvénients des étages usuels.

Un autre objet d'un mode de réalisation de la présente invention est de proposer une solution plus particulièrement adaptée à un asservissement du courant minimum dans les transistors de sortie.

Un autre objet d'un mode de réalisation de la présente invention est de proposer une solution permettant de réduire la tension d'alimentation de l'étage de sortie.

Un autre objet d'un mode de réalisation de la présente invention est de proposer une solution particulièrement adaptée aux circuits intégrés.

Pour atteindre tout ou partie de ces objets ainsi que d'autres, on prévoit un amplificateur comportant .
un étage de sortie dont deux premières bornes d'alimentation sont adaptées à recevoir une première tension définie par des premiers potentiels variables positif et négatif par rapport à un potentiel de référence ; et
un circuit d'asservissement du courant dans des transistors de l'étage de sortie à une valeur de référence, dans lequel :
   l'étage de sortie comporte un premier et un deuxième transistors MOS en série entre les deux premières bornes, le point milieu de cette association en série définissant une borne de sortie de l'amplificateur ;
   le circuit d'asservissement comporte deux transistors MOS de mesure dont les sources et grilles respectives sont couplées aux sources et grilles respectives des premier et deuxième transistors de l'étage de sortie ;
   au moins une branche de commande, comportant des transistors en série entre deux bornes d'application d'une deuxième tension, définit des noeuds reliés aux grilles des transistors de sortie, ladite deuxième tension étant supérieure à la première.

Selon un mode de réalisation de la présentation, la première tension est susceptible d'atteindre une valeur inférieure à la tension de seuil d'un transistor MOS.

Selon un mode de réalisation de la présentation, la source de chaque transistor de mesure est connectée à la source du premier ou deuxième transistor par un élément résistif.

Selon un mode de réalisation de la présentation, les grilles respectives des premier et deuxième transistors sont connectées à des bornes de sortie du circuit d'asservissement.

Selon un mode de réalisation de la présentation, le circuit d'asservissement comporte au moins une paire différentielle de comparaison d'un courant de référence par rapport à une information représentative du courant le plus faible circulant dans les premier et deuxième transistors.

Selon un mode de réalisation de la présentation, le circuit d'asservissement commande le courant dans des branches parallèles auxquelles sont reliées les grilles des premier et deuxième transistors.

Selon un mode de réalisation de la présentation, le circuit d'asservissement commande le courant dans une branche à laquelle sont reliées les grilles des premier et deuxième transistors.

Selon un mode de réalisation de la présentation, les premier et deuxième transistors sont à canal N.

Selon un mode de réalisation de la présentation, les premier et deuxième transistors sont respectivement à canal P et à canal N.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 est un schéma bloc d'un mode de réalisation d'un étage de sortie d'amplificateur ;
la figure 2 est un schéma électrique d'un mode de réalisation de l'étage de sortie de la figure 1 ;
la figure 3 est un schéma bloc d'un mode de réalisation d'un amplificateur ;
la figure 4 est un schéma électrique d'un autre mode de réalisation de l'étage de sortie de la figure 1 ; et
la figure 5 est un schéma électrique d'une variante de la figure 2.

### Description détaillée

De mêmes éléments ont été désignés par de mêmes références aux différentes figures. Par souci de clarté, seuls les éléments utiles à la compréhension des modes de réalisation décrits ont été représentés et seront décrits. En particulier, la génération des signaux à amplifier et la destination de ces signaux n'ont pas été détaillées, les modes de réalisation décrits étant compatibles avec les applications usuelles.

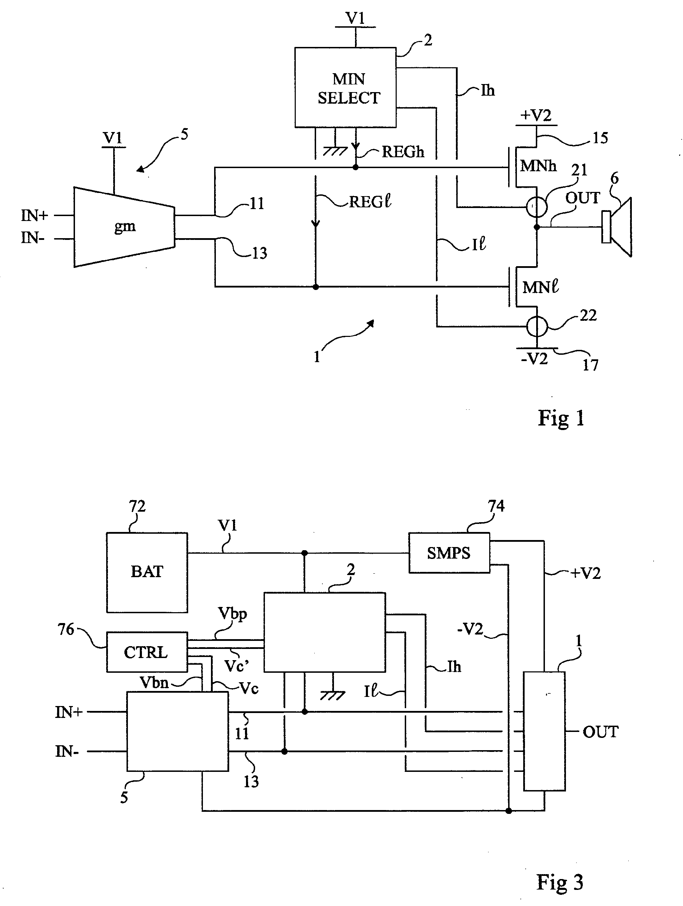

La figure 1 est un schéma bloc d'un mode de réalisation d'un amplificateur de puissance. Cet amplificateur comporte un étage de sortie 1 comportant deux transistors MOS à canal N MNh et MNl en série entre deux bornes 15 et 17 d'application de potentiels d'alimentation respectivement positif +V2 et négatif -V2, de préférence, mais non nécessairement, identiques. Une borne de sortie OUT de l'étage de sortie, destinée à être connectée à une charge 6 (par exemple un haut-parleur), est reliée entre les deux transistors MNh et MNl. Les grilles respectives des transistors MNh et MNl sont directement reliées à des bornes 11 et 13 d'entrée différentielle de l'étage de sortie.

L'exemple ci-dessus illustre le cas de deux transistors MOS à canal N en série. Toutefois, comme on le verra par la suite, l'étage de sortie peut comporter deux transistors MOS à canal P en série ou une association d'un transistor MOS à canal P et d'un transistor MOS à canal N.

Les deux bornes d'entrée différentielle 11 et 13 de l'étage de sortie 1 reçoivent des signaux provenant d'un étage d'entrée 5, ou d'un étage intermédiaire entre un étage d'entrée et l'étage de sortie. L'étage 5 reçoit, sur deux bornes d'entrée différentielle IN+ et IN-, un signal à amplifier. Deux sorties de l'étage 5 sont reliées aux bornes 11 et 13.

Pour simplifier, on fera par la suite référence à un étage d'entrée pour désigner l'étage 5 mais on notera que le nombre d'étages intermédiaires d'amplification entre l'application des signaux à amplifier et l'étage de sortie dépend des applications.

Dans un étage de sortie du type illustré par la figure 1, un seul des deux transistors MNh et MNl fonctionne à un instant donné, soit pour fournir un courant à la sortie (transistor MNh), soit pour prélever un courant sur la sortie (transistor MNl), selon le signe du signal amplifié par rapport à un niveau de mode commun (généralement la masse).

Le montage de la figure 1 comporte en outre un circuit 2 d'asservissement des courants dans les transistors MNh et MNl. Le circuit 2 exploite deux informations Ih et Il représentatives des courants de source respectifs des transistors MNh et MNl. Ces informations sont mesurées par des moyens 21 et 22 représentés symboliquement en figure 1. Le circuit 2 fixe le courant dans les transistors en jouant sur les potentiels de grille respectifs des transistors MNh et MNl par deux signaux REGh et REGI.

Une architecture telle qu'illustrée en figure 1 correspond approximativement à l'architecture décrite dans le brevet américain 5055797 susmentionné. Dans ce document, les éléments 21 et 22 sont constitués de résistances, préjudiciables au fonctionnement de l'amplificateur.

Dans les modes de réalisation qui vont être décrits, les moyens 21 et 22 n'introduisent pas d'éléments résistifs dans l'association en série des transistors MNh et MNl.

Le circuit 2 a pour rôle de déterminer le courant minimum parmi les courants Ih et Il et de comparer ce courant minimum à un courant de référence. Le transistor dans lequel circule le courant le plus faible est celui qui ne fournit pas le signal de sortie. Le circuit 2 asservit ce courant minimum à un niveau de référence. Les deux transistors restent passants tant que l'amplificateur est actif, afin de ne pas engendrer de problèmes liés aux commutations.

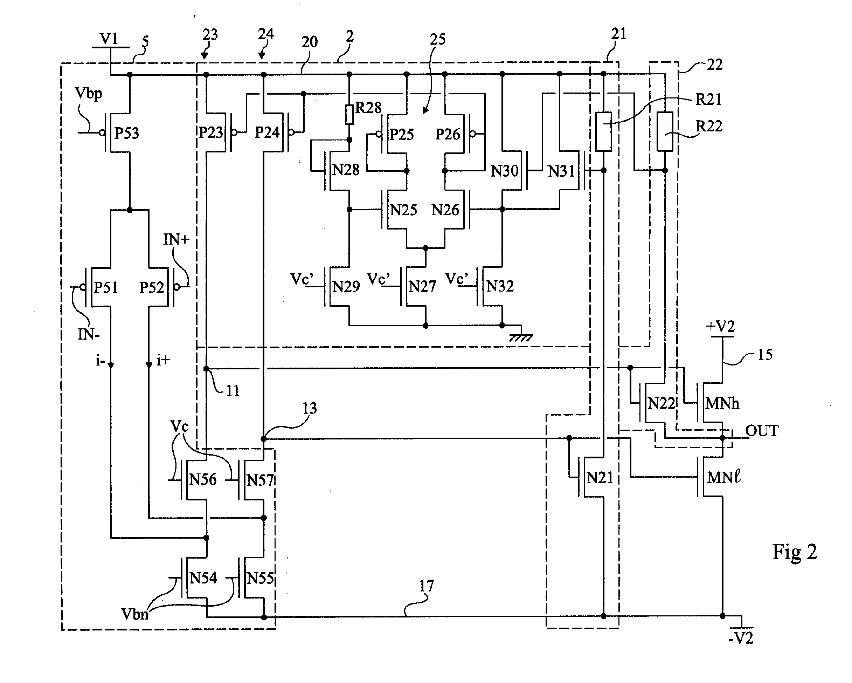

La figure 2 est un schéma électrique d'un mode de réalisation d'un étage de sortie d'amplificateur et d'un circuit 2 d'asservissement du courant des transistors de sortie.

L'étage d'entrée 5 (ou étage de sortie différentielle de l'étage précédent) comporte, par exemple, deux transistors P51 et P52 à canal P dont les grilles respectives définissent les bornes IN- et IN+ et dont les sources sont reliées, par l'intermédiaire d'un transistor MOS P53 à canal P, à une borne 20 d'application du potentiel V1. Les drains respectifs des transistors P51 et P52 sont reliées à la borne 17 d'application du potentiel -V2 par des transistors N54 et N55 à canal N.

Les transistors P53, N54 et N55 sont des transistors de polarisation dont les grilles respectives reçoivent, pour le transistor à canal P (P53), une tension Vbp et, pour les transistors à canal N (N54 et N55), une tension Vbn. Les tensions de polarisation Vbn et Vbp sont généralement générées dans le circuit intégré par des montages en miroir de courant qui ne font pas l'objet des modes de réalisation décrits et que l'on retrouve dans tout circuit à base de transistors MOS.

Les drains respectifs des transistors P51 et P52 sont par ailleurs reliés, par l'intermédiaire de transistors MOS N56 et N57, à canal N, jouant le rôle de cascodes, aux bornes 11 et 13.

Les noeuds 11 et 13 sont par ailleurs reliés à la borne 20 d'application du potentiel V1 par deux transistors MOS à canal P P23 et P24. Ces transistors appartiennent au circuit 2 et sont commandés, comme le verra par la suite, pour réguler les courants dans les transistors MNh et MNl. Pour l'instant, on se contente de noter que ces transistors P23 et P24 sont respectivement en série avec les transistors N56, N54 et N57, N55 entre les bornes 20 et 17. Ces associations en série forment deux branches 23 et 24 en parallèle entre les bornes 20 et 17 et jouent un rôle de conversion courant-tension pour commander les grilles des transistors MNh et MNl en fonction d'une variation des courants dans les transistors P52 et P51 reflétant une variation de la différence de potentiels entre les bornes d'entrée IN+ et IN-. Les transistors P23 et P24 définissent des sources de courant commandables fixant les courants minimum dans les transistors MNh et MNl.

De façon usuelle, un déséquilibre entre les potentiels appliqués aux bornes IN+ et IN- se traduit par un déséquilibre entre les courants i+ et i- des drains des transistors P52 et P51. Ce déséquilibre est reporté dans les branches 23 et 24 de commande des grilles des transistors MNh et MNl et se traduit par une variation des courants dans ces transistors, donc une variation du niveau de la tension de sortie Vout.

Par rapport à une position d'équilibre, une diminution du courant i+ dans le transistor P52 (et une augmentation du courant i-) dans le transistor P51 se traduit par une augmentation du courant dans le transistor N57 et une diminution du courant dans le transistor N56 et, par voie de conséquence, une diminution du courant dans le transistor MNl et une augmentation du courant dans le transistor MNh, ce qui provoque une augmentation de la tension de sortie. A l'inverse, une diminution du courant i+ et une augmentation du courant i-provoquent une diminution de la tension Vout.

Dans le mode de réalisation décrit, la polarisation des transistors P23 et P24 est asservie en fonction d'une valeur de référence, pour maintenir à une valeur suffisante au fonctionnement de l'étage de sortie, le courant minimum des transistors MNh et MNl.

Les éléments 21 et 22 de mesure de l'information représentative du courant dans les transistors MNh et MNl sont constitués d'une résistance R21, respectivement R22, en série avec un transistor MOS à canal N N21, respectivement N22, entre la borne 20 et les sources respectives des transistors MNl (donc la borne 17) et MNh (donc la borne OUT). Les grilles respectives des transistors N21 et N22 sont connectées aux grilles des transistors MNl et MNh. Les transistors N21 et N22 sont de taille inférieure à celle des transistors MNl et MNl. Les courants qui traversent les transistors N21 et N22 sont proportionnels au courants traversant respectivement les transistors MNl et MNh. Les résistances R21 et R22 servent d'élément de conversion courant-tension pour exploiter ces mesures. Tout autre moyen de conversion pourra être utilisé.

Le circuit 2 forme un circuit de comparaison du courant minimum, parmi ceux des deux branches 21 et 22, par rapport à un courant de référence. L'étage de comparaison est constitué d'une paire différentielle 25 comportant deux branches en parallèle entre la borne 20 et un transistor MOS de polarisation N27, à canal N, relié à la masse et commandé par un signal Vc'. Chaque branche comporte un transistor MOS P25, P26, à canal P, en série avec un transistor MOS N25, N26 à canal N. Les transistors P25 et P26 sont montés en diode (grilles et drains reliés). Par ailleurs, le transistor P26 est monté en miroir de courant avec les transistors P23 et P24 en ayant sa grille reliée aux grilles de ces deux transistors. La grille du transistor N25 est reliée au point milieu d'une branche de référence, formée d'une résistance R28 et de deux transistors MOS à canal N N28 et N29 en série entre la borne 20 et la masse. Le transistor N29 est un transistor de polarisation commandé par le signal Vc'. Le transistor N28 est monté en diode (grille et drain reliés). La paire différentielle 25 compare les courants fournis par les circuits de mesure 21 et 22 au courant dans cette branche de référence. Pour cela, la grille du transistor N26 est reliée à la borne 20 par deux transistors MOS à canal N N30 et N31 en parallèle dont les grilles respectives sont reliées aux points milieux des associations en série du transistor N22 et de la résistance R22 et du transistor N21 et de la résistance R21. La grille du transistor N26 est reliée à la masse par un transistor N32 de polarisation commandé par le signal Vc'.

Le circuit 2 ajuste le courant dans les branches 23 et 24 en fonction du courant dans celui des transistors MNl ou MNh dans lequel circule le courant le plus faible (le transistor inactif), pour que ce courant soit égal au courant minimum.

Ce courant dépend du courant de référence, du rapport de taille entre les transistors MNh et MNl et les transistors de mesure N21 et N22, du courant dans les transistors N30 et N31, des valeurs des résistances R21, R22 et R28 et de la taille des transistors N28, N30 et N31. L'objectif est de permettre à l'alimentation à découpage (non représentée) fixant les potentiels +V2 et -V2 de réduire le plus possible la tension appliquée entre les bornes 15 et 17 (typiquement inférieure à 0,7 volt).

La tension 2V2 (+V2-(-V2)) est régulée à une valeur la plus faible possible et la tension V1 est fixe et choisie pour autoriser un fonctionnement du circuit 2 au pire cas, c'est-à-dire pour que le noeud 13 puisse atteindre un potentiel correspondant à la tension de sortie OUT majorée d'une tension grille-source de transistor MOS à canal N (celle du transistor MNl). Dissocier la tension d'alimentation de l'étage de sortie de la tension d'alimentation du circuit d'asservissement (et de l'étage d'entrée) autorise un abaissement supplémentaire de la tension 2V2.

La limite basse pour la tension 2V2 (+V2-(-V2)) est liée à la tension minimale pour que les transistors MNh et MNl restent passants et, grâce à l'asservissement de leurs tensions grille-source sur une valeur minimale, cette tension peut descendre à quelques centaines de millivolts (jusqu'à environ 200 mV), en dessous d'une tension seuil d'un transistor MOS.

Un avantage de l'étage de sortie et du circuit d'asservissement illustrés par la figure 2 est que la fiabilité des mesures des courants dans les transistors de sortie est améliorée. En particulier, cette mesure est indépendante de variations de température et de variations dans les tensions seuil des transistors. En effet, les transistors MNl et N21, ainsi que MNh et N22, sont des transistors auxquels est appliquée la même tension grille-source.

Par rapport à une solution dans laquelle des résistances sont insérées dans la branche de sortie, le mode de réalisation décrit autorise un fonctionnement avec une tension d'alimentation encore plus faible en minimisant les chutes de tension dans la branche de sortie.

A titre de variante, le circuit 2 peut comporter deux paires différentielles du type de la paire 25, respectivement affectées à chacun des transistors de sortie, donc à chacune des branches 23 et 24. Une telle modification ne pose pas de difficultés.

Ce qui a été décrit en relation avec la figure 2 sur la base d'un étage de sortie composé de transistors MOS à canal N se transpose à un étage de sortie composé de transistors MOS à canal P. Tous les transistors MOS à canal N de la figure 2 sont remplacés par les transistors à canal P et tous les transistors à canal P sont remplacés par des transistors à canal N.

Par ailleurs, ce qui a été décrit ci-dessus se transpose également à une alimentation V1 négative par rapport à la masse. Dans ce cas, le circuit 2 se retrouve entre la masse et cette alimentation négative.

La figure 3 est un schéma-bloc d'un circuit incluant un amplificateur tel qu'illustré par la figure 2. Ce circuit comporte, entre autres, une source d'alimentation 72, par exemple une batterie (BAT), un régulateur de tension, une alimentation à découpage, etc., fournissant la tension fixe V1 et une alimentation à découpage 74 (SMPS) générant, par exemple à partir de la tension V1 les potentiel variables +V2 et -V2. L'alimentation à découpage reçoit une information (liaison non représentée) sur la tension de sortie pour réguler les potentiels +V2 et -V2. Un circuit de commande 76 (CTRL) fournit les tensions de polarisation Vc et Vc' ainsi que les tensions de polarisation Vbp et Vbn. Une telle architecture est en elle-même usuelle.

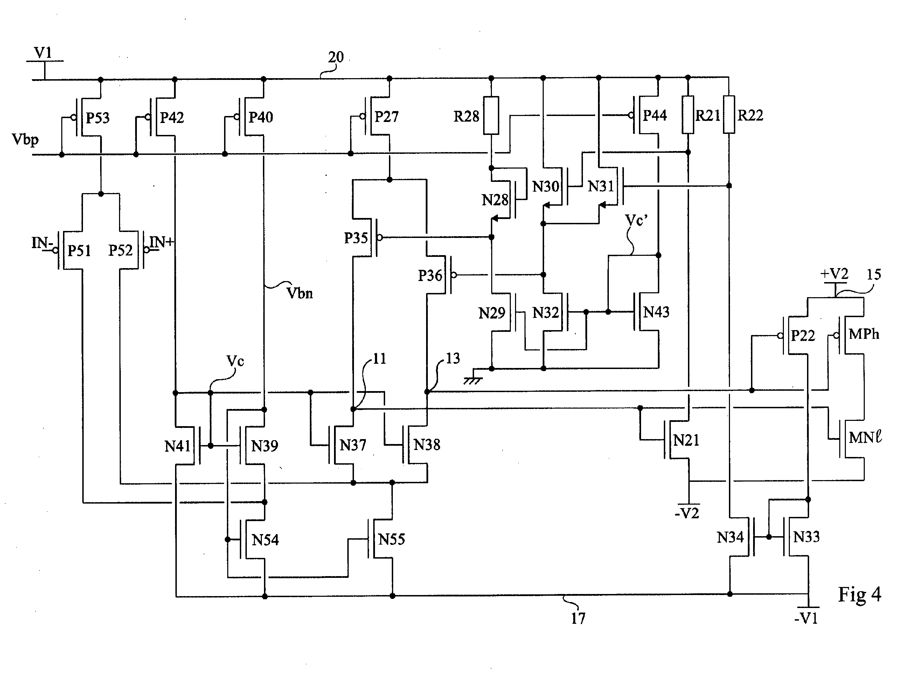

La figure 4 est un schéma électrique représentant un autre mode de réalisation dans lequel l'étage de sortie est constitué d'un transistor MOS à canal P MPh en série avec un transistor MOS à canal N MNh. Par rapport au circuit de la figure 2, le transistor N22 devient un transistor P22 à canal P et ce transistor est associé en série avec un transistor à canal N N33 monté en diode et en miroir de courant sur un transistor à canal N N34 reliant la résistance R22 à la borne 17, la source du transistor P22 étant connectée directement à la borne 15.

Par ailleurs, les transistors N33, N34, N54 et N55 ont leurs sources reliées à un potentiel fixe -V1, différent du potentiel -V2 auxquelles sont reliées les sources des transistors MNl et N21. Le potentiel -V1, égal ou différent en valeur absolue du potentiel V1, est inférieur au potentiel de référence (généralement la masse) auquel sont connectés les transistors N29, N32 et N43. Un potentiel -V1 différent du potentiel -V2 permet le fonctionnement des transistors P22 et MPh, même avec une tension -V2 faiblement négative.

Côté circuit 2, le montage est modifié pour tenir compte de la modification de l'étage de sortie. Par ailleurs, des montages de génération, à partir du potentiel Vbp, des potentiels de polarisation Vbn, Vc et Vc' ont été illustrés.

Les transistors N25 et N26 sont donc remplacés par des transistors à canal P, P35 et P36, dont les sources sont reliées à la borne 20 par un transistor P27 de polarisation recevant la tension Vbp sur sa grille. Les drains des transistors P35 et P36 sont reliés par des transistors à canal N, N37 et N38, au drain du transistor N55. Le transistor N54 est relié, par un transistor N39 à canal N et un transistor P40 à canal P en série, à la borne 20. Le transistor P40 est polarisé par le signal Vbp et son drain fournit le potentiel de polarisation Vbn. Les transistors N37, N38 et N39 sont montés en cascode sur un transistor N41, monté en diode et relié, par un transistor P42 à canal P, à la borne 20. Le transistor P42 est polarisé par le signal Vbp. Le drain du transistor N41 fournit le potentiel Vc. Enfin, les transistors N29 et N32 sont montés en miroir de courant sur un transistor N43 à canal N, monté en diode et en série avec un transistor P44 à canal P entre les bornes 20 et de masse, le transistor P44 étant polarisé par le potentiel Vbp. L'ensemble du montage est mis sous tension à partir du signal Vbp. La transposition des montages de polarisation au circuit de la figure 2 est à la portée de l'homme du métier.

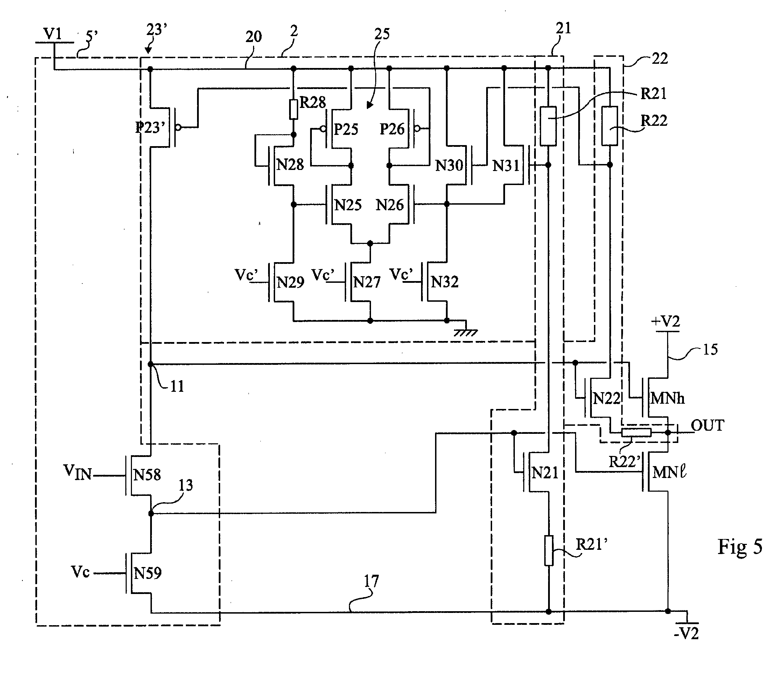

La figure 5 représente une variante de la figure 2, adaptée à un étage d'entrée 5' non différentiel. Par rapport à la figure 2, une borne d'entrée de cet étage 5' reçoit une tension Vin à amplifier. Cette tension est appliquée sur la grille d'un transistor MOS à canal N N58. Ce transistor est intercalé dans une branche 23' entre un transistor P23' de sortie du circuit 2 (commandé comme les transistors P23 et P24 de la figure 2), relié à la borne 20, et un transistor de polarisation à canal N N59 relié à la borne 17. Le transistor N59 est commandé par le signal Vc. La borne 13 (reliée aux grilles des transistors N21 et MNl) correspond au point milieu entre les transistors N58 et N59. Le fonctionnement du circuit de la figure 4 se déduit des fonctionnements exposés précédemment.

La figure 5 illustre une autre variante selon laquelle des résistances R21' et R22' (optionnelles) sont intercalées entre le transistor N21 et la borne 17 et entre le transistor N22 et la borne OUT. Cela permet de diminuer le courant dans les branches de mesure. Cette variante est transposable aux autres modes de réalisation.

A titre d'exemple non limitatif de réalisation, un amplificateur tel qu'illustré par la figure 2 peut être réalisé avec les valeurs suivantes:
résistances R21 et R22 : de l'ordre de 80 kohms ;
rapport de taille entre les transistors de mesure et ceux de l'étage de sortie : de l'ordre de 1/100 ;
tension V1 : environ 3,6 volts ; et
tension V2 : variable entre environ 0,2 et 2 volts.

Divers modes de réalisation ont été décrits. Diverses variantes et modifications apparaîtront à l'homme de l'art. En particulier, les dimensions à donner aux différents transistors et résistances sont à la portée de l'homme du métier à partir des indications fonctionnelles données ci-dessus et des tensions d'alimentation auxquelles est destiné l'amplificateur. Par ailleurs, bien que les modes de réalisation ci-dessus aient été décrits en relation avec des exemples de circuits ne comportant que des transistors MOS, ces réalisations se transposent à des circuits réalisées partiellement avec des transistors bipolaires, pourvu que les transistors de mesure (N21 et N22 ou P22) et d'amplification (MNl et MNh ou MPh) restent des transistors MOS. Une telle transposition est à la portée de l'homme du métier.

## Revendications

1. Amplificateur comportant :
un étage de sortie (1) dont deux premières bornes (15, 17) d'alimentation sont adaptées à recevoir une première tension définie par des premiers potentiels variables positif (+V2) et négatif (-V2) par rapport à un potentiel de référence ; et
un circuit (2) d'asservissement du courant dans des transistors de l'étage de sortie à une valeur de référence, **caractérisé en ce que** :
l'étage de sortie comporte un premier et un deuxième transistors MOS (MNh, MNl ; MPh, MNl) en série entre les deux premières bornes, le point milieu de cette association en série définissant une borne (OUT) de sortie de l'amplificateur ;
le circuit d'asservissement comporte deux transistors MOS de mesure (N21, N22 ; N21, P22) dont les sources et grilles respectives sont couplées aux sources et grilles respectives des premier et deuxième transistors de l'étage de sortie ;
au moins une branche de commande (23, 24 ; 23'), comportant des transistors en série entre deux bornes d'application d'une deuxième tension, définit des noeuds (11, 13) reliés aux grilles des transistors de sortie, ladite deuxième tension étant supérieure à la première.

2. Amplificateur selon la revendication 1, dans lequel la première tension est susceptible d'atteindre une valeur inférieure à la tension de seuil d'un transistor MOS.

3. Amplificateur selon la revendication 1 ou 2, dans lequel la source de chaque transistor de mesure est connectée à la source du premier ou deuxième transistor par un élément résistif (R21', R22').

4. Amplificateur selon l'une quelconque des revendications 1 à 3, dans lequel les grilles respectives des premier et deuxième transistors (MNh, MNl ; MPh, MNl) sont connectées à des bornes de sortie du circuit d'asservissement.

5. Amplificateur selon l'une quelconque des revendications 1 à 4, dans lequel le circuit d'asservissement (2) comporte au moins une paire différentielle (25) de comparaison d'un courant de référence par rapport à une information représentative du courant le plus faible circulant dans les premier et deuxième transistors (MNh, MNl ; MPh, MNl).

6. Amplificateur selon l'une quelconque des revendications 1 à 5, dans lequel le circuit d'asservissement (2) commande le courant dans des branches parallèles (23, 24) auxquelles sont reliées les grilles des premier et deuxième transistors (MNh, MNl ; MPh, MNl).

7. Amplificateur selon l'une quelconque des revendications 1 à 5, dans lequel le circuit d'asservissement (2) commande le courant dans une branche (23') à laquelle sont reliées les grilles des premier et deuxième transistors (MNh, MNl ; MPh, MNl).

8. Amplificateur selon l'une quelconque des revendications 1 à 7, dans lequel les premier et deuxième transistors (MNh, MNl) sont à canal N.

9. Amplificateur selon l'une quelconque des revendications 1 à 7, dans lequel les premier et deuxième transistors sont respectivement à canal P (MPh) et à canal N (MNl).

## Patentansprüche

1. Ein Verstärker, der folgendes aufweist:
eine Ausgangsstufe (1), mit zwei Leistungsversorgungsanschlüssen (15, 17) um eine erste Spannung zu empfangen und zwar definiert durch erste positive (+V2) und negative (-V2) variable Potentiale bezüglich eines Referenzpotentials; und
eine Schaltung (2) zur Servosteuerung des Stroms in Transistoren der Ausgangsstufe mit einem Referenzwert, **dadurch gekennzeichnet dass** die Ausgangsstufe folgendes aufweist:
einen ersten und einen zweiten MOS Transistor (MNh, MN1; MPh, MN1) in Serie zwischen den ersten zwei Anschlüssen, wobei der Verbindungspunkt dieser Serienverbindung einen Ausgangsanschluss (OUT) des Verstärkers definiert;
wobei die Steuerschaltung zwei Mess-MOS-Transistoren (N21, N22; N21, P22) aufweist, deren entsprechende Sources und Gates in entsprechenden Sources and Gates der ersten und zweiten Transistoren der Ausgangsstufe gekoppelt sind;
mindestens ein Steuerzweig (23, 24; 23') der Transistoren in Serie zwischen zwei Anschlüssen aufweist, zum Anlegen einer zweiten Spannung und zwar Knoten (11, 13) definierend, verbunden mit den Gates der Ausgangstransistoren, wobei die zweite Spannung größer als die erste Spannung ist.

2. Der Verstärker nach Anspruch 1, wobei die erste Spannung in der Lage ist, einen Wert zu erreichen, der kleiner ist als die Schwellenspannung eines MOS-Transistors.

3. Der Verstärker nach Anspruch 1 oder 2, wobei die Source jedes Messtransistors verbunden ist mit der Source des ersten oder zweiten Transistors und zwar durch ein Widerstandselement (R21', R22').

4. Der Verstärker nach einem der Ansprüche 1 bis 3, wobei die entsprechenden Gates der ersten und zweiten Transistoren (MNh, MN1; MPh, MN1) mit Ausgangsanschlüssen der Steuerschaltung verbunden sind.

5. Der Verstärker nach einem der Ansprüche 1 bis 4, wobei die Steuerschaltung (2) mindestens ein Differentialpaar (25) aufweist zum Vergleichen eines Referenzstromes mit Daten repräsentativ für den niedrigsten durch die ersten und zweiten Transistoren (MNh, MN1; MPh, MN1) fließenden Stroms.

6. Der Verstärker nach einem der Ansprüche 1 bis 5, wobei die Steuerschaltung (2) den Strom in Parallelzweigen (23, 24) steuert mit denen die Gates der ersten und zweiten Transistoren (MNh, MN1; MPh, MN1) verbunden sind.

7. Der Verstärker nach einem der Ansprüche 1 bis 5, wobei die Steuerschaltung (2) den Strom in einen Zweig (23') steuert mit dem die Gates der ersten und zweiten Transistoren (MNh, MN1; MPh, MN1) verbunden sind.

8. Der Verstärker nach einem der Ansprüche 1 bis 7, wobei die ersten und zweiten Transistoren (MNh, MN1) N-Kanal-MOS-Transistoren sind.

9. Der Verstärker nach einem der Ansprüche 1 bis 7, wobei die ersten und zweiten Transistoren jeweils P-Kanal (MPh) und N-Kanal (MN1) MOS-Transistoren sind.

## Claims

1. An amplifier comprising:
an output stage (1) having two first power supply terminals (15, 17) for receiving a first voltage defined by first positive (+V2) and negative (-V2) variable potentials with respect to a reference potential; and
a circuit (2) for servo controlling the current in transistors of the output stage at a reference value, **characterized in that**:
the output stage comprises a first and a second MOS transistor (MNh, MNl; MPh, MNl) in series between the first two terminals, the junction point of this series connection defining an output terminal (OUT) of the amplifier;
the control circuit comprises two measurement MOS transistors (N21, N22; N21, P22) having their respective sources and gates coupled to the respective sources and gates of the first and second transistors of the output stage;
at least one control branch (23, 24; 23'), comprising transistors in series between two terminals of application of a second voltage, defines nodes (11, 13) connected to the gates of the output transistors, said second voltage being greater than the first one.

2. The amplifier of claim 1, wherein the first voltage is capable of reaching a value smaller than the threshold voltage of a MOS transistor.

3. The amplifier of claim 1 or 2, wherein the source of each measurement transistor is connected to the source of the first or second transistor by a resistive element (R21', R22').

4. The amplifier of any of claims 1 to 3, wherein the respective gates of the first and second transistors (MNh, MNl; MPh, MNl) are connected to output terminals of the control circuit.

5. The amplifier of any of claims 1 to 4, wherein the control circuit (2) comprises at least one differential pair (25) for comparing a reference current with data representative of the lowest current flowing through the first and second transistors (MNh, MNl; MPh, MNl).

6. The amplifier of any of claims 1 to 5, wherein the control circuit (2) controls the current in parallel branches (23, 24) to which the gates of the first and second transistors (MNh, MNl; MPh, MNl) are connected.

7. The amplifier of any of claims 1 to 5, wherein the control circuit (2) controls the current in a branch (23') to which are connected the gates of the first and second transistors (MNh, MNl; MPh, MNl).

8. The amplifier of any of claims 1 to 7, wherein the first and second transistors (MNh, MNl) are N-channel MOS transistors.

9. The amplifier of any of claims 1 to 7, wherein the first and second transistors are respectively P-channel (MPh) and N-channel (MNl) MOS transistors.
